(19) Europäisches Patentamt

European Patent Office

Office européen des brevets

(11) Veröffentlichungsnummer: **0 369 143**

**A1**

(12) # EUROPÄISCHE PATENTANMELDUNG

(21) Anmeldenummer: **89117923.6**

(22) Anmeldetag: **28.09.89**

(51) Int. Cl.⁵: **C23C 16/30**

(30) Priorität: **06.10.88 DE 3834356**

(43) Veröffentlichungstag der Anmeldung:
**23.05.90 Patentblatt 90/21**

(84) Benannte Vertragsstaaten:
**BE CH DE ES FR GB IT LI LU NL SE**

(71) Anmelder: **SCHERING AKTIENGESELLSCHAFT**
**Berlin und Bergkamen**
**Müllerstrasse 170/178 Postfach 65 03 11**
**D-1000 Berlin 65(DE)**

(72) Erfinder: **Suhr, Harald, Prof.-Dr.**
**Weissdornweg 2**
**D-7400 Tübingen(DE)**
Erfinder: **Schmid, Reiner**
**Wöhrwoldweg 43**
**D-7410 Reutlingen(DE)**
Erfinder: **Traus, Iris**
**Hauptstrasse 28**
**D-7408 Kusterdingen-Wankheim(DE)**

(54) **Verfahren zur Herstellung dünner Molybdänsulfidfilme.**

(57) Die Erfindung betrifft ein Verfahren zur Herstellung dünner Moybdänsulfidfilme, bei denen die physikalischen Eigenschaften in weiten Bereichen variiert und auf gewünschte Werte eingestellt werden können, dadurch gekennzeichnet, daß die Ab scheidung aus der Gasphase erfolgt.

EP 0 369 143 A1

## VERFAHREN ZUR HERSTELLUNG DÜNNER MOLYBDÄNSULFIDFILME

Die Erfindung betrifft ein Verfahren zur Herstellung dünner Molybdänsulfid-Filme gemäß Oberbegriff des Anspruchs 1.

Die Herstellung von Molybdänsulfidfilmen ist an sich bekannt. Es sind verschiedene Verfahren zur Herstellung durch kathodische Zerstäubung (RF-Sputtern) von aus gepresstem Molybdändisulfidpulver bestehenden Targets beschrieben worden. Mit der Anwendung dieser Technik sind jedoch gravierende Nachteile verbunden. So stellten Mikkelsen et al. Appl. Phys. Lett. 52 (14), 1130 (1988) fest, daß die durch RF-Sputtern erhaltenen Filme, mit kristallinem Molybdändisulfid verglichen, nur eine sehr geringe Dichte aufweisen, da das auf diese Weise hergestellte Material im kristallinen Aufbau sehr ungeordnet ist und hohe Anteile an Verunreinigungen aufweist.

Dadurch sind die physikalischen Eigenschaften gegenüber kristallinem Molybdänsulfid deutlich verschlechtert. Die Dichte dieser Filme konnte durch eine Nachbehandlung (400 kV Argon-Ionenbombardement) auf den Wert kristallinen Materials erhöht werden. Die dabei auftretenden enormen Leistungsdichten (ieinige Watt/cm$^2$) beschränken diese Herstellungsmethode jedoch auf wenige Materialien. Weiterhin wird von zum Teil erheblichen Verunreinigungen der Filme durch Wasser berichtet, welches die physikalischen Eigenschacten des Molybdänsulfids negativ beeinflußt. Dies ist zum einen darauf zurückzuführen, daß die Kathoden gekühlt werden müssen, um eine Aufheizung der Targets zu verhindern, sodaß Restwasser kondensieren kann; zum anderen nimmt das Molybdändisulfid-Pulver der Targets Wasser auf, da es in gepulvertem, feinverteiltem Zustand hygroskopisch ist. Diese Probleme sind durch die In situ-Darstellung des Molybdänsulfids nach dem erfindungsgemäßen Verfahren praktisch ausgeschlossen. Ein weiterer nachteil der beschriebenen Verfahren besteht in der Schwierigkeit, ausreichende Haftfestigkeiten auf den Substratmaterialien zu erreichen. Zur Realisierung einer ausreichenden Adhäsion müssen häufig Adhäsionspromotoren oder Leimschichten eingesetzt werden.

Der Einsatzbereich der bekannten Verfahren ist beschränkt, so daß gegen Sputterprozesse außerordentlich sensible Substrate wie zum beispiel Aluminiumoxidkeramiken, Aluminiumnitridkeramiken oder Edelstahl nicht problemlos beschichtet werden können. Ebenso gegen höhere Temperaturen empfindliche Materialien wie beispielsweise Teflon, Polyimid, Epoxidharze oder andere Kunststoffe können wegen der hohen Energiedichten nicht eingesetzt werden.

Die vorliegende Erfindung hat zur Aufgabe, fest haftende dünne Schichten von Molybdänsulfid variabler Zusammensetzung auf beliebigen Substraten herzustellen. Die elektrischen und tribologischen Eigenschaften dieser Filme sind in weiten Bereichen variabel und können auf gewünschte Werte eingestellt werden. Die so hergestellten Halbzeuge werden vorzugsweise im Bereich der Vakuumtechnik, der Luft- und Raumfahrt in Fahrzeugen des Straßen- und Schienenverkehrs sowie in anderen Bereichen des Maschinenbaus eingesetzt. Interessant ist der Einsatz dieser Schichten insbesondere zur Trockenschmierung von Lagern und Gleitflächen, die extremer thermischer Beanspruchung unterliegen, da die thermische Beständigkeit dieser Schichten sehr hoch ist.

Wegen der katalytischen Eigenschaften können die Schichten, auf geeignete Trägermaterialien abgeschieden, auch in der chemischen Industrie als Katalysatoren verwendet werden. Darüber hinaus ist ein Einsatz der Molybdänsulfidfilme wegen der elektrischen und chemischen Eingenschaften in der Sensortechnik von Interesse.

Die elektrischen und optischen Eigenschaften von Molybdänsulfidfilmen erschließen darüber hinaus Einsatzgebiete in der Mikro- und Optoelektronik.

Der Einsatz für diese Anwendungen von mit der RF-Sputtertechnik hergestellten Molybdänsulfidfilmen ist wegen der weiter vorn genannten Eigenschaften nur mit Einschränkungen in Bezug auf Bandstruktur und Zustandsdichte möglich. Da die elektronischen Eigenschaften der im kristallinen Aufbau stark gestörten Materialien nicht produzierbar einstellbar sind, ist ihr Einsatz in mikro- und optoelektronischen Anwendungen in diesem Fall nicht gegeben.

Die Aufgabe wird gelöst durch ein Verfahren gemäß dem kennzeichnenden Teil des Patentanspruchs.

Weitere Ausgestaltungen der Erfindung sind in den Unteransprüchen beschrieben.

Das erfindungsgemäße Verfahren überwindet die genannten Nachteile der herkömmlichem Techniken, beziehungsweise mildert diese deutlich ab, indem die Herstellung der Molybdänverbindungen in Gegenwart von schwefelhaltigen Reaktivgasen in einem Plasma vorgenommen wird. Hierbei werden, je nach Behandlungszeit, Schichten von einigen hundert bis etwa 5000 A erhalten. Als Molybdänquelle ist Molybdänhexacarbonyl besonders gut geeignet, da es luftbeständig ist, bequem zu dosieren und wegen seines Sauerstoffgehaltes auch zur Herstellung oxidenthaltender Filme verwendet werden kann. Es können jedoch auch andere flüchtige Molybdänverbindungen eingesetzt werden.

Als Schwefelquelle kann vorzugsweise Schwefelwasserstoffgas eingesetzt werden. Es ist jedoch möglich, auch Schwefelkohlenstoff, Kohlenoxysulfid oder andere flüchtige Schwefelverbindungen zu verwenden.

Die Metallisierung erfolgt in normalen Plasmareaktoren, die hauptsächlich als Rohr- oder Tunnelreaktoren oder als Parallelplattenreaktoren und Reaktoren für Coronaentladungen bekannt sind. Für die Herstellung der Molybdänsulfidfilme kann das Plasma sowohl mit Gleichstrom als auch mit Wechselstrom oder Hochfrequenz (inklusive Mikrowellen), im allgemeinen im kHz- oder MHz-Bereich erzeugt werden. Der Druck in der Plasmakammer beträgt 5-100 Pa. Als Substrate kommen beliebige Materialien zum Einsatz: Polymere wie Polyimid, Epoxidharze, Polyethylen oder -propylen, Teflon, Polycarbonat, Polyester-Kondensationsprodukte wie Phenol/Formaldehyd-Kunststoffe unter anderem Hochleistungspolymere, Keramiken wie Aluminiumoxid, Aluminiumnitrid, Bornitrid, Zirkonoxid unter anderem., Gläser wie Quarz- oder Silikatglas unter anderem und Metalle wie zum Beispiel Edelstähle, vermickelte Stähle, Metalle mit Oxid- oder Nitridschichten, Kupfer, Titan unter anderem. Die für die Beschichtung nach erfindungsgemäßen Verfahren benutzten Molybdän- und Schwefelverbindungen werden dem Plasmareaktor gasförmig zugeführt, vorzugsweise durch Sublimation oder Verdampfung.

Sie können für sich allein benutzt werden, im allgemeinen verdünnt man sie aber mit Trägergasen, um gleichmäßige porenfreie Schichten zu erhlaten. Als Trägergase eignen sich inerte Gase, wie Argon und Helium oder reduzierende Gase wie Wasserstoff; auch Gemische können eingesetzt werden. Die Einspeisung der Molybdän- und Schwefelverbindungen erfolgt nach Einstellung des Vakuums außerhalb der Glimmetladungszone in den Strom des Trägergases, sodaß im eigentlichen Reaktionsbereich eine gleichmäßige Gasmischung vorliegt.

Die Vorratsbehälter für die Metallverbindung werden zweckmäßigerweise mit einer Vorrichtung zum Heizen versehen, um auch höhere Partialdampfdrucke realisieren zu können.

Eine alternative Ausführungsform des erfinduhngsgemäßern Verfahrens besteht darin, daß vor dem Metallisierungsprozess in der Plasmaentladung ein Plasma-Ätzprozess vorgenommen wird, um die Substratoberfläche zu reinigen und für die Aufnahme der Metallschicht empfänglich zu machen. Die Ausführungsform des Reaktors und der Verfahrensbedingungen unterscheiden sich im Prinzip nicht von dem Plasma-Metallisierungsprozess. Selbstverständlich werden jedoch beim Plasma-Ätzprozess keine metallorganischen Verbindungen verwendet. Vorzugsweise werden dem inerten Trägergas reaktive Gase, wie zum Beispiel Sauerstoff oder Tetrafluormethan-Sauerstoff zugesetzt.

Die Einspeisung der Molybdänverbindung in die Glimmentladungszone erfolgt nach Herstellung des Vakuums zusammen mit dem Reaktivgasgemisch, sodaß im eigentlichen Reaktionsbereich eine gleichmäßige Gasmischung vorliegt.

Durch die Glimmentladung wird sowohl das Substrat angeätzt als auch die Molybdänsulfidschicht erzeugt. Dabei werden durch Reaktion aus der Molybdänerbindung mit der Schwefelverbindung reine Kohlenstoff-, Kohlenstoff-/Sauerstoff-oder sauerstoffhaltige Schichten erzeugt. Durch Einstellung der Verfahrensparameter können daher Schichten mit unterschiedlichen Eigenschaften bezüglich Molybdän-/Schwefelverhältnis, elektrischer, optischer und tribologischer Eigenschaften gezielt hergestellt werden.

Wird die elektrische Leistung der Glimmentladung verringert, werden Filme von geringerer Dichte bei steigendem Molybdän/Schwefel-Verhältnis und geringeren spezifischen Widerständen erhalten.

Erhöht man den Anteil an Reaktivgas, steigt der Schwefel-Anteil in den Filmen und man erhält in Abhängigkeit von der angewandten Leistungsdichte Filme mit Molybdän/Schwefel-Verhältnissen zwischen 0.7 und 1.4 und mit geringeren Dichten. Der elektrische Widerstand der Filme bleibt dabei nahezu unverändert.

Arbeitet man mit reinen Argon-Schwefelwasserstoff-Gasgemischen ohne Wasserstoffzusatz fällt das Molybdän/Schwefelverhältnis auf Werte unter 1.3. Auch die Dichte der Filme nimmt dadurch ab, während die spezifischen elektrischen Widerstände um ca. 2 Zehnerpotenzen steigen.

Die Substrattemperatur beträgt vorzugsweise zwischen Raumtemperatur und 175° C, es können jedoch in speziellen Fällen andere Temperaturen angewandt werden.

Die folgenden Beispiele dienen zur Erläuterung der Erfindung.

| BEISPIEL 1 | |
|---|---|
| Substrat | - Silikat oder Quarzglas |
| Molybdänverbindung | - $Mo(CO)_6$ |
| Trägergas | - Argon/Wasserstoff 2 : 1 |
| Reaktivgas | - Schwefelwasserstoff |
| Gasfluß | - Ar: 7sccm*, $H_2S$: 0.25sccm |
| Elektrodentemperatur | - 175 °C |
| Heizung des Vorratsbehälters | - entfällt |
| Reaktor | - Parallelplattenreaktor |
| Frequenz | - HF (13.56 MHz) |
| Leistungsdichte | - 0.75 Watt/$cm^2$ |
| Druck im Reaktor | - 20 Pa |
| Reaktionsdauer | - 60 min für 0.2 μm Filmdicke |

\* sccm = Standard-$cm^3$

| Eigenschaften: | |
|---|---|
| Dichte (ber.): | - 4.8 g/$cm^3$ (kristallines Molybdänsulfid: 4,8 g/$cm^3$) |
| spez. Widerstand: | - 1.2 Ωcm (0,1 - 10.1 Ωcm, je nach Darstellung). |
| Atomverhältnis Mo/S: | - 1.7 (im $MoS_2$:Mo/S = 1.5) |
| Farbe: | - schwarz glänzend |

BEISPIEL 2

Unter den im Beispiel 1 angegebenen Arbeitsbedingungen wurden nacheinander auch verschiedene andere Substrate (Keramik (Aluminiumoxid, Aluminiumnitrid), Epoxid, Polyimid, Edelstahl) beschichtet, wobei jedesmal schwarz glänzende, gleitfähige, elektrisch leitende Filme von ca. 2000 Å Schichtdicke entstanden.

Die spezifischen elektrischen Widerstände wurden nach der Vierpunkt-Methode mit einem Gerät von Kulicke und Soffa, Modell 331, gemessen. Eine Überprüfung dieser Werte nach mehrwöchigem Stehenlassen an feuchter Luft zeigte keine Veränderungen.

Die oben angeführten Eigenschaften wurden mit sog. "as deposited" - Filmen erzielt, das heißt so wie sie unter den gegebenen Bedingungen im Reaktor entstanden. Ein wie bei anderen Verfahren zur Realisierung meist notwendiges Annealing (nachträgliche Wärmebehandlung zur Verbesserung der Kristallstruktur) oder andere Nachbehandlungen müssen hier nicht angewendet werden.

**Ansprüche**

1. Verfahren zur Herstellung dünner Molybdänsulfidfilme, bei denen die physikalischen Eigenschaften in weiten Bereichen variiert und auf gewünschte Werte eingestellt werden können, dadurch gekennzeichnet, daß die Abscheidung aus der Gasphase erfolgt.

2. Verfahren nach Anspruch 1, dadurch gekennzeichnet, daß flüchtige Molybdänverbindungen zusammen mit flüchtigen Schwefelverbindungen als Reaktivgas in einer Glimmentladung zersetzt werden.

3. Verfahren nach Anspruch 2, dadurch gekennzeichnet, daß als Molybdänquelle Molybdänhexacarbonyl verwendet wird.

4. Verfahren nach Anspruch 2, dadurch gekennzeichnet, daß als Schwefelverbindung Schwefelwasserstoff eingesetzt wird.

5. Verfahren nach Anspruch 2, dadurch gekennzeichnet, daß dem Reaktionsgasgemisch Trägergase zugemischt werden.

6. Verfahren nach Anspruch 1, dadurch gekennzeichnet, daß die Molybdänsulfidfilme auf Nichtleitern

4

oder leitenden Substraten abgeschieden werden.

7. Verfahren nach Anspruch 6, dadurch gekennzeichnet, daß das Substrat vor der Beschichtung einem Ätz- und Reinigungsprozess in einer Glimmentladung unterworfen werden.

8. Molybdänsulfidfilme hergestellt nach den Verfahren gemäß Ansprüchen 1 bis 7.

9. Verwendung der Molybdänsulfidfilme gemäß Anspruch 8 zur Herstellung selbstschmierender Schichten.

10. Verwendung der Molybdänsulfidfilme gemäß Anspruch 8 zur Herstellung elektrooptischer Schichten.

11. Verwendung der Molybdänsulfidfilme gemäß Anspruch 8 zur Herstellung chemisch katalytischer Schichten zum Einsatz in der chemischen Industrie und in der Sensorik.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PROCEEDINGS OF ELECTROCHEMICAL SOCIETY-PROCEEDINGS OF THE SYMPOSIUM ON PRIMARY AND SECONDARY AMBIENT TEMPERATURE LITHIUM BATTERIES, Santa Fe, New Mexico, 1988, Band 88-6, Seiten 464-476, The Electrochemical Society Inc., Manchester, NH, US; D.M. SCHLEICH et al.: "MoS3 Thin Film Cathodes Prepared by Chemical Vapor Deposition" * Seite 464, Zeilen 1-4 * --- | 1,6,8 | C 23 C 16/30 |
| A | CHEMICAL ABSTRACTS, Band 96, 1982, Seite 520, Zusammenfassung Nr. 27739s, Columbus, Ohio, US; G.N. KARTMAZOV et al.: "Pyrolysis of molybdenum hexacarbonyl in a glow discharge", & DEPOSITED DOC. 1980, VINITI 5438-80, 11 pp. * Zusammenfassung * --- | 2,3 | |
| A,D | APPLIED PHYSICS LETTERS, Band 52, Nr. 14, 4. April 1988, Seiten 1130-1132, American Institute of Physics, New York, US; N.J. MIKKELSEN et al.: "Friction and wear measurements of sputtered MoSx films amorphized by ion bombardment" ----- | | **RECHERCHIERTE SACHGEBIETE (Int. Cl.5)** C 23 C H 01 M |

Der vorliegende Recherchenbericht wurde für alle Patentansprüche erstellt

| Recherchenort | Abschlußdatum der Recherche | Prüfer |
|---|---|---|
| DEN HAAG | 15-01-1990 | PATTERSON A.M. |